Europäisches Patentamt

European Patent Office

Office européen des brevets

(11) Numéro de publication: **0 299 894 B1**

(19)

(12) **FASCICULE DE BREVET EUROPEEN**

(45) Date de publication de fascicule du brevet: **07.10.92**   (51) Int. Cl.⁵: **H01L 21/60**, H01L 23/50

(21) Numéro de dépôt: **88420246.6**

(22) Date de dépôt: **13.07.88**

(54) **Procédé et structure de prise de contact sur des plots de circuit intégré.**

(30) Priorité: **16.07.87 FR 8710413**

(43) Date de publication de la demande:
**18.01.89 Bulletin 89/03**

(45) Mention de la délivrance du brevet:
**07.10.92 Bulletin 92/41**

(84) Etats contractants désignés:
**DE FR GB IT NL**

(56) Documents cités:
**DE-A- 2 658 302**
**FR-A- 2 492 164**

**PATENT ABSTRACTS OF JAPAN, vol. 9, no. 270 (E-353)[1993], 26 octobre 1985; & JP-A-60 116 157 (MATSUSHITA DENKI SANGYO K.K.) 22-06-1985**

(73) Titulaire: **SGS-THOMSON MICROELECTRO-NICS S.A.**
**7, Avenue Galliéni**
**F-94250 Gentilly(FR)**

(72) Inventeur: **Gloton, Jean-Pierre**
**3, rue du Rich**
**F-13100 Aix en Provence(FR)**

(74) Mandataire: **de Beaumont, Michel et al**
**1bis, rue Champollion**
**F-38000 Grenoble(FR)**

## Description

La présente invention concerne un procédé et une structure de prise de contact sur des plots de circuit intégré. Elle s'applique notamment dans le cas où cette prise de contact doit se faire par l'intermédiaire de bossages formés sur ces plots.

De façon générale dans le domaine des circuits intégrés à semiconducteurs, on utilise comme couche(s) de connexion des couches d'aluminium. En effet, il s'agit là d'un métal très bon conducteur de l'électricité, facile à déposer, même sur des surfaces présentant des reliefs inégaux, facile à graver, et relativement peu coûteux. Ces couches de connexion en aluminium se terminent par des plots, généralement de forme carrée, disposés à la périphérie de la puce de circuit intégré pour permettre de reprendre un contact vers des connexions extérieures.

Là par contre se pose un difficulté car l'aluminium est très facilement oxydable et forme souvent des composés intermétalliques isolants avec d'autres matériaux conducteurs. On a donc développé diverses technologies de prise de contact dans lesquelles on commence par déposer des structures conductrices adaptées multicouches sur les plots d'aluminium.

Le problème se pose de façon particulièrement aiguë quand, sur ces plots d'aluminium, on veut réaliser des bossages conducteurs tels qu'on les utilise par exemple pour un montage par le procédé dit TAB. Selon ce procédé, des métallisations de connexion vers l'extérieur sont formées sur un film analogue aux films de cinématographie, des portions de métallisation sur ces films, ou poutres, étant ensuite appliquées contre les bossages du circuit intégré qui est présenté dans une fenêtre ouverte dans le film de sorte que ces bossages se trouvent en face des extrémités des poutres.

Un procédé classique de l'art antérieur pour réaliser de tels bossages consiste à déposer uniformément sur un circuit intégré dans lequel des ouvertures ont été ménagées au dessus des plots d'aluminium, une pulvérisation du TiW puis d'or. Ensuite, une couche de résine est disposée uniformément sur la pastille et des fenêtres sont ouvertes aux emplacements des plots. Une électrolyse d'or épais (de 0,02 à 0,03 mm) est réalisée. Puis la résine est éliminée par attaque chimique et la couche de TiW + Au est éliminée par gravure ionique aux emplacements autres que ceux où est formé le bossage.

Les opérations de dépôt et d'élimination de la couche de TiW + Au sont des étapes particulièrement complexes qui nécessitent un appareillage coûteux. Ainsi, de façon générale, les fabricants de circuits intégrés à semiconducteurs qui ne sont pas amenés à utiliser très souvent des liaisons par bossage, par exemple pour TAB, plutôt que d'investir lourdement pour acquérir le matériel nécessaire, sous-traitent les opérations de réalisation des bossages. Ceci entraîne également une augmentation importante du coût du circuit intégré.

Ainsi, un objet de la présente invention est de prévoir un nouveau type de contact sur plot d'aluminium qui soit particulièrement simple à mettre en oeuvre et qui ne nécessite pas une technologie complexe par rapport aux technologies couramment utilisées dans le domaine de la fabrication des circuits intégrés à semiconducteurs.

Un autre objet de la présente invention est de prévoir un tel procédé particulièrement adapté à la formation de contacts à bossage.

Pour atteindre ces objets, l'idée fondamentale de la présente invention qui s'oppose aux habitudes de l'art antérieur est que, étant donné qu'il est difficile de faire un contact avec une couche d'aluminium, on forme sous cette couche d'aluminium une couche avec laquelle on sait bien faire un contact et l'on établit le contact avec cette couche inférieure qui assure la liaison électrique avec la couche d'aluminium.

Ainsi, le procédé de formation de contact sur un plot d'aluminium de circuit intégré selon la présente invention comprend les étapes suivantes : prévoir sus le plot d'aluminium une sous-couche conductrice en un matériau assurant un bon contact électrique avec l'aluminium ; éliminer localement la couche d'aluminium pour laisser apparaître une partie de la surface de la sous-couche ; et établir une connexion avec la sous-couche. La sous-couche peut selon le cas avoir une surface inférieure, égale ou supérieure à celle du plot.

Selon un mode de réalisation de la présente invention, la sous-couche est une couche de silicium polycristallin dopé.

Selon un mode de réalisation de la présente invention, la connexion avec la surface apparente de la couche de silicium polycristallin est établie au moyen d'une goutte de colle conductrice.

Ainsi, un plot de contact de circuit intégré selon la présente invention comprend une couche délimitée de silicium polycristallin au moins partiellement revêtue d'une couche d'aluminium comprenant des prolongements établissant des connexions avec le circuit intégré.

Ces objets, caractéristiques et avantages ainsi que d'autres de la présente invention seront exposés plus en détail dans la description suivant de modes de réalisation particuliers faite en relation avec les figures jointes parmi lesquelles :

la figure 1 représente une vue de dessus de plots de contact classiques d'un circuit intégré ;

les figures 2A et 2B représentent deux exemples de vues en coupe selon la ligne II-II de la figure 1 ;

les figures 3A et 3B représentent une vue en coupe et une vue de dessus d'une structure de contact selon la présente invention, la figure 3A étant une coupe selon la ligne IIIA-IIIA de la figure 3B ; et

la figure 4 représente une vue en coupe d'un montage à bossage associé à une structure de contact selon la présente invention.

Dans ces diverses figures, les dimensions et les épaisseurs de couche ne sont pas tracées à l'échelle pour simplifier la lisibilité des figures, comme cela est classique dans le domaine de la représentation des circuits à semiconducteurs.

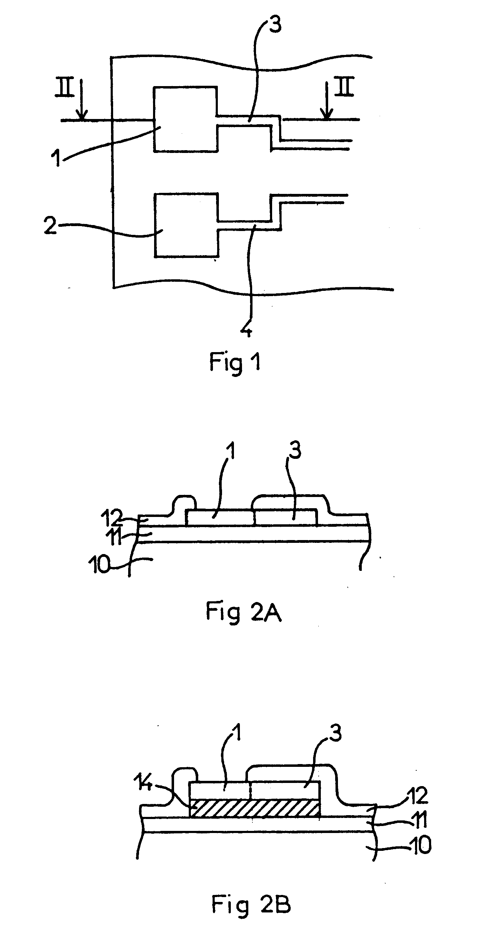

La figure 1 représente une vue de dessus partielle d'un bord d'un circuit intégré comprenant de plots de contact 1 et 2 en aluminium. Généralement, ces plots de contact d'aluminium sont solidaires de bandes de connexion en aluminium 3 et 4 allant établir des contacts en des emplacements choisis du circuit intégré. Toutefois, pour certains plots, il peut ne pas exister de bande de connexion, le plot étant destiné à établir un contact avec le substrat sousjacent.

Les figures 2A et 2B représentent deux exemples de vues en coupe selon la ligne II-II de la figure 1.

En figure 2A, la couche d'aluminium 1, 3 est déposée sur un substrat semiconducteur 10 par l'intermédiaire d'une couche isolante 11, couramment une couche d'oxyde de silicium épaisse (épaisseur supérieure à un micromètre) également appelée dans la technique couche d'oxyde de champ. Ensuite, dans la plupart des réalisations de circuit intégré, une couche épaisse (plusieurs micromètres) d'un matériau isolant, par exemple de la silice dopée au phosphore 12 est déposée sur l'ensemble du circuit intégré et des fenêtres sont ouvertes au dessus du plot de contact 1. C'est à l'intérieur de ces fenêtres que l'on cherche à établir des contacts vers l'extérieur du circuit intégré.

La figure 2B représente un autre exemple de vue en coupe de la structure de la figure 1. La différence entre les figures 2B et 2A est qu'en figure 2B une couche conductrice de silicium polycristallin existe sous les couches d'aluminium. Une telle configuration apparaît systématiquement pour des raisons qui ne seront pas exposées ici dans certaines technologies de fabrication de circuit intégré. Toutefois, dans l'art antérieur, même dans le cas où une telle couche de silicium polycristallin 14 existe sous les zones de plots d'aluminium, les contacts sont quand même établis par une métallurgie de contact avec l'aluminium comme dans le cas où une telle couche sousjacente n'existe pas.

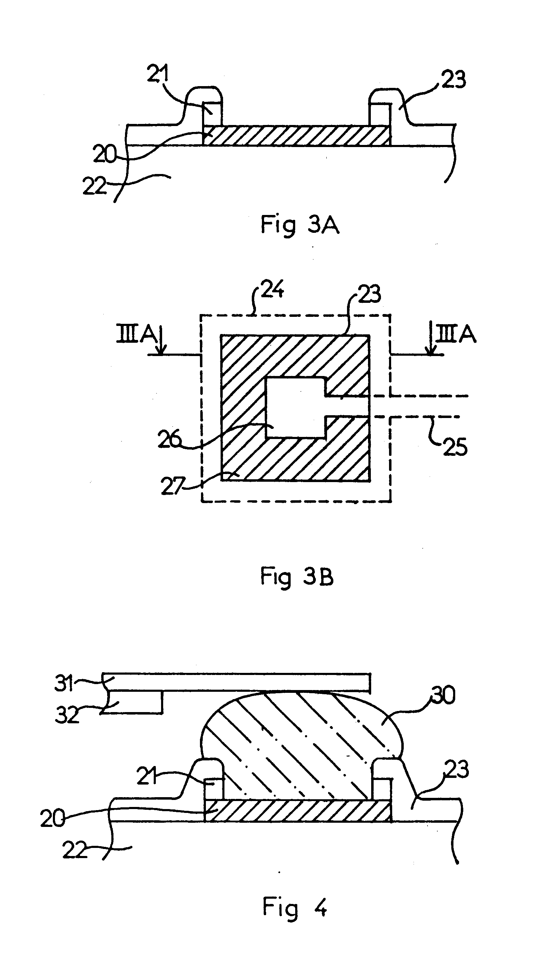

Les figures 3A et 3B représente un exemple de structure de contact selon la présente invention. Comme le représente la figure 3A, cette structure de contact comprend systématiquement une couche de silicium polycristallin 20 conducteur, c'est-à-dire fortement dopé, sous une couche d'aluminium 21. Cette couche d'aluminium est ouverte pour laisser apparaître en surface une partie notable de la couche de silicium polycristallin 20. Cette couche de silicium polycristallin 20 repose elle-même sur un substrat 22 qui peut être ou bien directement un substrat de silicium si on cherche à établir un contact avec celui-ci, ou bien une couche isolante, par exemple une couche de $SiO_2$ épais déposée sur une plaquette de silicium.

Ensuite, le plot selon la présente invention peut être relié par tout moyen connu permettant d'établir une connexion avec du silicium polycristallin, cette connexion étant beaucoup plus facile à réaliser qu'avec de l'aluminium. On a également représenté en figure 3A une couche de passivation supérieure 23 ouverte aux emplacements où l'on souhaite établir le contact.

La figure 3B est une vue de dessus permettant de mieux voir la délimitation des diverses couches. La référence 23 désigne la limite de la couche de passivation supérieure, le pointillé 24 désigne la limite extérieure de la couche d'aluminium 21 qui, dans l'exemple représenté, s'étend un peu en dessous de la couche de passivation 23 et se prolonge par une bande de connexion 25. En outre, dans l'exemple représenté en figure 3B, la couche d'aluminium 21 n'est pas complètement gravée à l'intérieur du contour défini par le masque 23 mais on a laissé en place une zone centrale d'aluminium 26, seule une partie hachurée 27 de la couche de silicium polycristallin 20 étant apparente. Cette région interne d'aluminium 26 est destinée à augmenter la surface de contact entre le silicium polycristallin et l'aluminium pour tenir compte du fait que le silicium polycristallin dopé n'est pas un aussi bon conducteur que l'aluminium. Après cela, tout procédé de reprise de contact sur du silicium polycristallin dopé peut être utilisé.

La figure 4 représente un exemple de réalisation particulier dans un cas où l'on veut réaliser des bossages et un montage du type TAB.

La figure 4 représente une connexion particulièrement simple à un plot de contact selon la présente invention. Sur la structure telle que représentée en figure 3A et désignée en figure 4 par les mêmes références, on dépose une goutte de colle conductrice 30. Ceci permet, par exemple, d'établir une liaison avec une poutre 31 en débordement sur un film support 32 selon le procédé TAB. En outre, la colle permet aussi d'assurer la fixation avec la poutre. Un avantage supplémentaire de ce mode de montage est que, même si les poutres 31 ne sont pas dans le même plan horizontal, un léger enfoncement dans la colle 30 est possible si l'on opère à une température et à un état où cette colle est encore visqueuse.

Comme colle conductrice 30, on peut utiliser un produit dans lequel le porteur est, par exemple, du silicone, de l'époxy, du polyimide ou du verre, et où la charge conductrice est de l'argent, de l'or, du paladium, etc.

On notera que cette utilisation particulièrement simple d'un point de colle ne serait pas possible avec un plot à surface apparente en aluminium, les interfaces colle conductrice-aluminium étant de forte ohmicité.

Un montage selon la présente invention, par exemple tel qu'illustré en figure 4 se prête tout particulièrement au cas de circuits intégrés comprenant un faible nombre de bornes, par exemple les circuits intégrés utilisés pour les cartes à mémoire telles que les cartes bancaires, les cartes téléphoniques, etc., cartes couramment designées dans le langage courant par l'expression "carte à puce".

Bien entendu, l'exemple particulier de la figure 4 ne constitue qu'un exemple de réalisation de la présente invention et tout procédé connu de connexion sur du silicium polycristallin peut être utilisé, par exemple un alliage. De façon générale, l'invention s'étend au procédé général consistant à prévoir un plot de connexion comprenant, sous une couche d'aluminium, une sous-couche conductrice avec laquelle est effectivement effectuée une reprise de contact. Cette sous-couche pourrait, par exemple, être constituée de nickel, de cuivre, de verre conducteur, etc.

## Revendications

1. Procédé de prise de contact sur un plot en aluminium de circuit intégré, caractérisé en ce qu'il comprend les étapes suivantes :
   - prévoir sous le plot d'aluminium (21, 26) une sous-couche conductrice en un matériau (20) assurant un bon contact électrique avec l'aluminium.
   - éliminer localement la couche d'aluminium pour laisser apparaître une partie (27) de la surface de la sous-couche, et
   - établir une connexion avec la sous-couche.

2. Procédé selon la revendication 1, caractérisé en ce que la sous-couche est une sous-couche de silicium polycristallin dopé.

3. Procédé selon la revendication 2 caractérisé en ce que la connexion avec la surface apparente de la couche de silicium polycristallin est établie au moyen d'une goutte de colle conductrice (30).

4. Plot de contact de circuit intégré, caractérisé en ce qu'il comprend une couche délimitée d'un matériau assurant un bon contact électrique avec l'aluminium (20) au moins partiellement revêtue d'une couche d'aluminium (21, 26) comprenant des prolongements (25) établissant des connexions avec le circuit intégré.

5. Plot de contact de circuit intégré selon la revendication 4, caractérisé en ce que la partie de couche d'aluminium formée sur ledit matériau comprend une région sensiblement centrale élargie (26) prolongée vers une connexion (25).

6. Plot de contact selon la revendication 4, caractérisé en ce que ledit matériau est du silicium polycristallin dopé.

7. Plot de contact selon l'une des revendications 4 à 6, caractérisé en ce qu'il est recouvert d'une goutte de colle conductrice (30).

8. Plot de contact selon la revendication 7, caractérisé en ce que la goutte de colle (30) établit également une liaison électrique et mécanique avec un conducteur électrique externe (31).

## Claims

1. A method for contacting an integrated circuit aluminum pad, characterized in that it comprises the following steps:
   - providing beneath the aluminum pad (21, 26) a conductive underlayer constituted of a material (20) insuring a good electrical contact with aluminum;
   - locally removing the aluminum layer for uncovering a portion (27) of the underlayer surface; and
   - establishing a connection with the underlayer.

2. A method according to claim 1, characterized in that the underlayer is a doped polycrystalline silicon underlayer.

3. A method according to claim 2, characterized in that the connection with the apparent surface of the polycrystalline silicon layer is established by means of a drop of conductive adhesive (30).

4. A contact pad for integrated circuits, characterized in that it comprises a delimited layer of a material insuring a good electrical contact with aluminum (20) at least partially covered with an aluminum layer (21, 26) comprising extensions (25) establishing connections with the integrated circuit.

5. A contact pad for integrated circuits according to claim 4, characterized in that the portion of aluminum layer formed on said material comprises a widened, substantially central, zone (26) extended towards a connection (25).

6. A contact pad according to claim 4, characterized in that said material is doped polycrystalline silicon.

7. A contact pad according to any of claims 4 to 6, characterized in that said pad is covered with a drop of a conductive adhesive (30).

8. A contact pad according to claim 7, characterized in that said drop of adhesive (30) also establishes an electrical and mechanical connection with an external electrical conductor (31).

**Patentansprüche**

1. Verfahren zur Herstellung einer Verbindung zu einem Aluminiumkontakt einer integrierten Schaltung, dadurch gekennzeichnet, daß es die folgenden Schritte aufweist:
   - Vorsehen einer leitenden Unterschicht unter dem Aluminiumkontakt (21, 26) aus einem Material (20), das einen guten elektrischen Kontakt mit dem Aluminium sicherstellt,
   - lokales Entfernen der Aluminiumschicht, um einen Teil (27) der Oberfläche der Unterschicht erscheinen zu lassen, und
   - Einrichten einer Verbindung mit der Unterschicht.

2. Verfahren nach Anspruch 1, dadurch gekennzeichnet, daß die Unterschicht eine Unterschicht aus polykristallinem dotierten Silizium ist.

3. Verfahren nach Anspruch 2, dadurch gekennzeichnet, daß die Verbindung mit der offenen Oberfläche der Unterschicht aus polykristallinem Silizium mit Hilfe eines Tropfens eines leitenden Leimes (30) hergestellt wird.

4. Kontakt für eine intergrierte Schaltung, dadurch gekennzeichnet, daß er eine begrenzte Schicht eines Materials aufweist, das einen guten elektrischen Kontakt mit Aluminium sicherstellt und das zumindest mit einer Aluminiumschicht (21, 26) bedeckt ist, wobei die Aluminiumschicht Verlängerungen (25) aufweist, die Verbindungen mit der integrierten Schaltung herstellen.

5. Kontakt für eine integrierte Schaltung nach Anspruch 4, dadurch gekennzeichnet, daß der Teil der Aluminiumschicht, die auf dem Material gebildet ist, eine im wesentlichen zentrale erweiterte Zone (26) aufweist, die in Richtung einer Verbindung (25) verlängert ist.

6. Kontakt nach Anspruch 4, dadurch gekennzeichnet, daß das Material polykristallines dotiertes Silizium ist.

7. Kontakt nach einem der Ansprüche 4 bis 6, dadurch gekennzeichnet, daß er mit einem Tropfen eines leitenden Leimes (30) bedeckt ist.

8. Kontakt nach Anspruch 7, dadurch gekennzeichnet, daß der Leimtropfen (30) eine elektrische und mechanische Verbindung mit einem externen elektrischen Leiter (31) bildet.

Fig 1

Fig 2A

Fig 2B

Fig 3A

Fig 3B

Fig 4